(19) Europäisches Patentamt / European Patent Office / Office européen des brevets

(11) **EP 4 521 123 B1**

(12) **EUROPEAN PATENT SPECIFICATION**

(45) Date of publication and mention
of the grant of the patent:
**04.03.2026 Bulletin 2026/10**

(21) Application number: **23866687.9**

(22) Date of filing: **30.08.2023**

(51) International Patent Classification (IPC):
**G01R 19/00** *(2006.01)* **G01R 15/20** *(2006.01)*

(52) Cooperative Patent Classification (CPC):
**G01R 19/0092;** G01R 15/205; G01R 15/207

(86) International application number:
**PCT/CN2023/115940**

(87) International publication number:
**WO 2025/000680 (02.01.2025 Gazette 2025/01)**

(54) **ALTERNATING CURRENT/DIRECT CURRENT MULTI-AIR-GAP MAGNETORESISTIVE CURRENT SENSOR AND CURRENT MEASUREMENT METHOD**

MAGNETORESISTIVER STROMSENSOR MIT MULTI-LUFT-KAPPE FÜR WECHSELSTROM UND GLEICHSTROM UND STROMMESSVERFAHREN

CAPTEUR DE COURANT MAGNÉTO-RÉSISTIF MULTI-ENTREFER À COURANT ALTERNATIF/ COURANT CONTINU ET PROCÉDÉ DE MESURE DE COURANT

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **26.06.2023 CN 202310762174**

(43) Date of publication of application:
**12.03.2025 Bulletin 2025/11**

(73) Proprietors:
• **China Electric Power Research Institute**
**Beijing 100192 (CN)**
• **China Electric Power Research Institute Wuhan Branch**
**Wuhan, Hubei 430070 (CN)**
• **State Grid Corporation of China (SGCC)**
**Beijing 100031 (CN)**

(72) Inventors:
• **ZHOU, Feng**
**Wuhan, Hubei 430070 (CN)**
• **YU, Jicheng**
**Wuhan, Hubei 430070 (CN)**
• **LIANG, Siyuan**
**Wuhan, Hubei 430070 (CN)**
• **YUE, Changxi**
**Wuhan, Hubei 430070 (CN)**
• **LEI, Min**
**Wuhan, Hubei 430070 (CN)**
• **YIN, Xiaodong**
**Wuhan, Hubei 430070 (CN)**
• **LI, Dengyun**
**Wuhan, Hubei 430070 (CN)**
• **XU, Zili**
**Wuhan, Hubei 430070 (CN)**
• **XIONG, Kui**
**Wuhan, Hubei 430070 (CN)**
• **ZHU, Kai**
**Wuhan, Hubei 430070 (CN)**
• **LI, Jiaxin**
**Wuhan, Hubei 430070 (CN)**

(74) Representative: **White, Andrew John et al**
**Mathys & Squire**
**The Shard**
**32 London Bridge Street**
**London SE1 9SG (GB)**

(56) References cited:
CN-A- 106 656 076     CN-A- 108 336 976
CN-A- 112 362 941     CN-A- 112 666 509
CN-A- 113 252 960     CN-A- 113 447 699
CN-A- 115 420 930     CN-U- 216 847 918
CN-U- 216 847 918     CN-Y- 2 663 991
CN-Y- 2 854 624

**Description**

CROSS-REFERENCE TO RELATED APPLICATIONS

This application claims the benefit of the Chinese Patent Application No. 202310762174.0, filed to the China National Intellectual Property Administration on June 26, 2023, and entitled "MULTI-AIR-GAP MAGNETORESISTANCE CURRENT SENSOR FOR ALTERNATING CURRENT AND DIRECT CURRENT, AND CURRENT MEASURING METHOD".

TECHNICAL FIELD

The disclosure relates to the technical field of electrical measurement, in particular to an alternating current/direct current (AC/DC) multi-air-gap magnetoresistance current sensor and a method for measuring a current.

BACKGROUND

The new power system has a high proportion of renewable energy and a high proportion of power electronic equipment. High-voltage and high-current contain complex components such as power frequency, harmonics and direct current, presenting characteristics of wide dynamic, strong random and strong time-varying. However, the existing mainstream current sensors are difficult to meet the measurement requirements of current signals in complex environments in terms of characteristics of accuracy and wide dynamic simultaneously. The mainstream current measurement device on the neutral line of the high-voltage direct current transmission system is a zero-flux type direct-current current transformer, which is difficult to measure high-frequency harmonics and has a poor insulation performance. Hall current sensor is often used for photovoltaic power station connected to power grid, which has limited accuracy and is susceptible to environmental disturbances such as temperature. In recent years, new magnetoresistance sensing technology with high sensitivity has been gradually applied, but there are some problems such as poor anti-interference ability, conductor eccentricity error, frequency response consistency, etc. Moreover, due to the influence of core magnetic hysteresis effect, the linear range and accuracy are limited. CN 2663991 Y discloses a current sensor, CN 115420930 A discloses high-performance zero-flux large-current sensor based on Hall effect, and CN 216847918 U discloses iron core-ring array multi-ring magneto-dependent current sensor.

SUMMARY

In view of this, an AC/DC multi-air-gap magnetoresistance current sensor and a method for measuring a current are proposed in the disclosure, which aims to solve the problems of poor anti-interference ability, conductor eccentricity error, frequency response consistency, the influence of magnetic hysteresis effect of iron core and so on of the existing sensing technology.

The invention is set out in the appended set of claims.

In the first aspect, the embodiment of the disclosure provides an AC/DC multi-air-gap magnetoresistance current sensor, including a magnetoelectric conversion unit, a signal processing unit and a feedback compensation unit. The magnetoelectric conversion unit is configured to: obtain a magnetic field signal of a target current-carrying wire with a to-be-measured current; and convert the magnetic field signal into an electric signal and output the electric signal to the signal processing unit. The magnetoelectric conversion unit includes an iron core and N new magnetoresistance elements connected in parallel, N air-gap openings are symmetrically arranged on the iron core, and the N new magnetoresistance elements are respectively located at centers of the N air-gap openings, $N \geq 3$ and N is a positive integer. The signal processing unit is configured to: amplify the electric signal output by the magnetoelectric conversion unit, and output the amplified signal to the feedback compensation unit. The feedback compensation unit is configured to: adjust a feedback current based on the amplified voltage signal output by the signal processing unit to enable the new magnetoresistance elements to operate at zero magnetic flux; measure a value of the feedback current; and obtain a value of the to-be-measured current based on the value of the feedback current, and output the value of the to-be-measured current.

Furthermore, the iron core is a circular magnetic gathering ring and is uniformly wound with a feedback winding, and the magnetoelectric conversion unit further includes a power supply circuit which is respectively connected to the N new magnetoresistance elements for power supply. When the target current-carrying wire with the to-be-measured current is placed at a center of the iron core, the N new magnetoresistance elements are used for obtaining the magnetic field signal of the target current-carrying wire with the to-be-measured current, converting the magnetic field signal into the electric signal and outputting the electric signal to the signal processing unit.

Furthermore, the operation that the N new magnetoresistance elements are used for obtaining the magnetic field signal of the target current-carrying wire with the to-be-measured current, converting the magnetic field signal into the electric signal and outputting the electric signal to the signal processing unit, includes obtaining an input voltage $V_i$ of each of the new magnetoresistance elements by the following formula:

$$V_i = K_i I_i (B_{in} - B_c)_;$$

where $K_i$ is a sensitivity of $i$-th new magnetoresistance element, $I_i$ is a control current of the $i$-th new magnetoresistance element, $B_{in}$ is a primary original magnetic field, and $B_c$ is a compensation magnetic field generated by the feedback current. Based on the input voltage of each new magnetoresistance element, a synthesis is performed and a combined voltage of the N new magnetoresistance elements is obtained according to an equivalent circuit of parallel capacitors, and the combined voltage is output to the signal processing unit.

Furthermore, the new magnetoresistance element is a tunneling magnetoresistance element.

Furthermore, the signal processing unit includes a detecting circuit, an interference suppression circuit, and a multi-band feedback circuit. The detecting circuit includes an instrumentation amplifier with three operational amplifiers. The detecting circuit is configured to amplify the voltage signal output by the magnetoelectric conversion unit, and output the amplified voltage signal to the feedback compensation unit. The interference suppression circuit is used for an element performance error correction circuit and a filtering circuit, the element performance error correction circuit is configured to generate a regulating current based on the voltage signal output by the magnetoelectric conversion unit, and the filtering circuit is configured to filter high-frequency magnetic field signals coupled by the new magnetoresistance elements to ensure a low-pass characteristic. The multi-band feedback circuit includes multiple dynamic output feedback control circuits for ensuring that the transmission characteristics of different frequencies are consistent, and each of the multiple dynamic output feedback control circuits has a limited frequency band.

Furthermore, the feedback compensation unit includes the feedback winding, a driving circuit and an output circuit. The feedback winding is uniformly wound on the iron core, and configured to pass the feedback current. The driving circuit is configured to adjust the feedback current output to the feedback winding based on the amplified voltage signal output by the signal processing unit, to enable a compensation magnetic field equal in size and opposite in direction to a primary magnetic field. The output circuit is configured to: measure the value of the feedback current, obtain the value of the to-be-measured current based on the value of the feedback current, and output the value of the to-be-measured current.

Furthermore, the operation of obtaining the value of the to-be-measured current based on the value of the feedback current includes dividing the value of the feedback current by a ratio of coil turns to obtain the value of the to-be-measured current.

Furthermore, the AC/DC multi-air-gap magnetoresistance current sensor further includes a ring housing for carrying the iron core wound with the feedback winding and the N new magnetoresistance elements connected in parallel.

Furthermore, the ring housing is voltage insulated by using an insulating layer.

In the second aspect, the embodiment of the disclosure provides a method for measuring a current, including: using the AC/DC multi-air-gap magnetoresistance current sensor provided by the above embodiments to measure a to-be-measured current in a target current-carrying wire, to obtain a value of the to-be-measured current and output the value of the to-be-measured current. The target current-carrying wire is at a center of an iron core of the AC/DC multi-air-gap magnetoresistance current sensor .

The AC/DC multi-air-gap magnetoresistance current sensor and the method for measuring a current are provided in the embodiments of the disclosure. The AC/DC multi-air-gap magnetoresistance current sensor adopts a multi-air-gap multi-band closed-loop iron core type structure, thereby improving the measurement performance of the current sensor, solving the problem of high accuracy and wide frequency domain consideration of AC/DC current measurement , providing technical guidance for the development and application of high-voltage and high-current measurement equipment, and promoting the technology upgrade of high-voltage and high-current measurement equipment.

BRIEF DESCRIPTION OF THE DRAWINGS

FIG. 1 illustrates a schematic structural diagram of an AC/DC multi-air-gap magnetoresistance current sensor according to an embodiment of the disclosure; and
FIG. 2 illustrates a schematic structural diagram of a housing of an AC/DC multi-air-gap magnetoresistance current sensor according to an embodiment of the disclosure.

DETAILED DESCRIPTION

Implementations of the disclosure are now described with reference to the accompanying drawings. However, the disclosure may be implemented in many different forms and is not limited to the embodiments described herein, and the embodiments are provided to thoroughly and completely disclose the disclosure and to fully convey the scope of the disclosure to those skilled in the technical field. The terms used in the implementations representing in the drawings is not a limitation to the disclosure. In the drawings, the same units/elements are indicated by the same reference numerals.

Unless otherwise stated, the terms (including technical terms) used herein have a common understanding to those skilled in the technical field. In addition, it is understood that terms defined in commonly used dictionaries should be understood to have meanings consistent with the context of their relevant fields, and should not be understood as an idealized or overly formal sense.

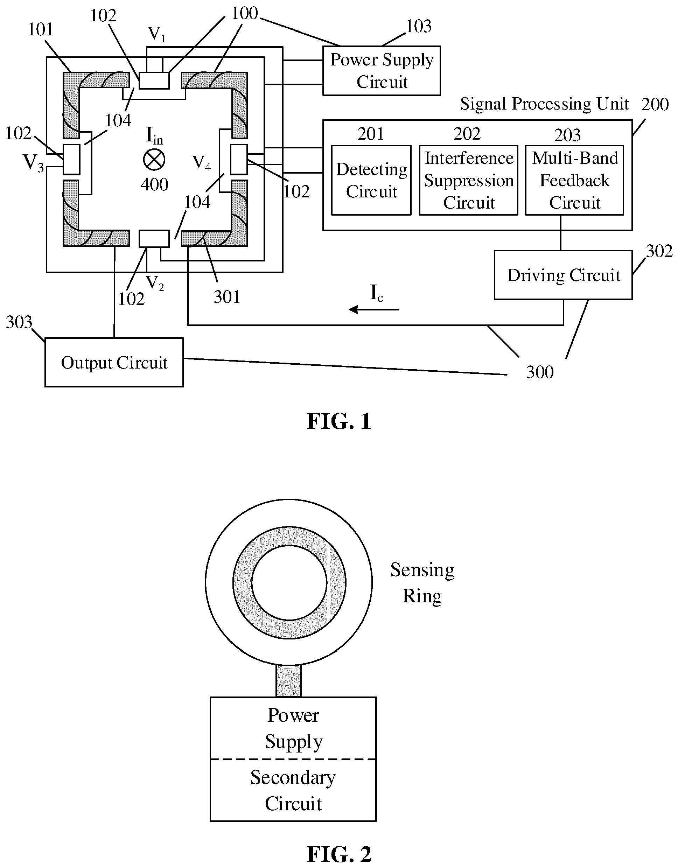

FIG. 1 illustrates a schematic structural diagram of an AC/DC multi-air-gap magnetoresistance current sensor according to an embodiment of the disclosure.

As illustrated in FIG. 1, the AC/DC multi-air-gap magnetoresistance current sensor includes: a magnetoelectric conversion unit 100, a signal processing unit 200 and a feedback compensation unit 300.

The magnetoelectric conversion unit 100 is configured to: obtain a magnetic field signal of a target current-carrying wire 400 with a to-be-measured current; and convert the magnetic field signal into an electric signal and outputting the electric signal to the signal processing unit 200. The magnetoelectric conversion unit 100 includes an iron core 101 and N new magnetoresistance elements 102 connected in parallel, N air-gap openings 104 are symmetrically arranged on the iron core 101, and the N new magnetoresistance elements 102 are respectively located at centers of the N air-gap openings 104, $N \geq 3$ and N is a positive integer.

Furthermore, the iron core 101 is a circular magnetic gathering ring and is uniformly wound with a feedback winding 301, and the magnetoelectric conversion unit further includes a power supply circuit 103 which is respectively connected to the N new magnetoresistance elements 102 for power supply.

When the target current-carrying wire 400 with the to-be-measured current is placed at a center of the iron core 101, the N new magnetoresistance elements 102 are used for obtaining the magnetic field signal of the target current-carrying wire 400 with the to-be-measured current, converting the magnetic field signal into the electric signal and outputting the electric signal to the signal processing unit 200.

The above embodiment adopts a multi-air-gap multi-band closed-loop iron core type structure, that is, the high interference sensitivity of the ring array current sensor is avoided through the magnetic gathering effect of the iron core, the wire eccentricity and non-uniform winding error of the single-air-gap iron core type structure are avoided through the multi-air-gap, and the hysteresis effect of the iron core is avoided through the zero magnetic flux closed-loop structure.

Furthermore, the operation that the N new magnetoresistance elements are used for obtaining the magnetic field signal of the target current-carrying wire with the to-be-measured current, converting the magnetic field signal into the electric signal and outputting the electric signal to the signal processing unit, includes that:

an input voltage $V_i$ of each new magnetoresistance element is obtained by the following formula (1):

$$V_i = K_i I_i (B_{in} - B_c) \qquad (1)$$

where $K_i$ is a sensitivity of i-th new magnetoresistance element, $I_i$ is a control current of the $i$-th new magnetoresistance element, $B_{in}$ is a primary original magnetic field, and $B_c$ is a compensation magnetic field generated by the feedback current; and

based on the input voltage of each new magnetoresistance element, a synthesis is performed and a combined voltage of the N new magnetoresistance elements is obtained according to an equivalent circuit of parallel capacitors, and the combined voltage is outputted to the signal processing unit.

Furthermore, the new magnetoresistance element is a tunneling magnetoresistance (TMR) element.

The above embodiment adopts new magnetoresistance element such as TMR and has the advantages of high sensitivity, wide frequency response range and the like.

The signal processing unit 200 is configured to: amplify the electric signal output by the magnetoelectric conversion unit 100, and output the amplified signal to the feedback compensation unit 300.

Furthermore, the signal processing unit 200 includes: a detecting circuit 201, an interference suppression circuit 202 and a multi-band feedback circuit 203.

The detection circuit 201 includes an instrumentation amplifier with three operational amplifiers. The detecting circuit is configured to amplify the voltage signal output by the magnetoelectric conversion unit, and outputting the amplified voltage signal to the feedback compensation unit.

The interference suppression circuit 202 is used for an element performance error correction circuit and a filtering circuit. The element performance error correction circuit is configured to generate a regulating current based on the voltage signal output by the magnetoelectric conversion unit. The filtering circuit is configured to filter high-frequency magnetic field signals coupled by the new magnetoresistance elements to ensure a low-pass characteristic.

The multi-band feedback circuit 203 includes multiple dynamic output feedback control circuits for ensuring that the transmission characteristics of different frequencies are consistent, and each of the multiple dynamic output feedback control circuits has a limited frequency band.

The detection circuit is configured to amplify the weak output voltage with small amplitude of TMR element for operations and filtering. The detection circuit is mainly composed of an instrumentation amplifier with three operational amplifiers, and its REF pin is grounded to keep a very low source impedance. In the detection circuit, a zeroing circuit is designed, in which a precision adjustable resistor is connected in series between two equivalent resistors, and a precision operational amplifier is used as a voltage follower for buffering. The positive input terminal of the precision operational amplifier is connected to the middle pin of the precision adjustable resistor, and its output serves as an output of a zeroing voltage.

The interference suppression circuit includes the element performance error correction circuit and the filtering circuit. The element performance error correction and compensation method based on a signal injection method is used through the decomposition unit according to the distinctive waveform characteristics, to identify the excitation signal from the current detected by TMR element, which is used to calculate the overall gain of the measuring loop of the magnetosensitive sensor, determine the change of the measurement characteristics of the magnetosensitive resistor chip, and generate a regulating current. The filter circuit is configured to filter the possibly coupled high-frequency magnetic field signal to ensure a low-pass characteristics. The filter circuit adopts a second-order Butterworth low-pass filter built based on a precision operational amplifier.

The multi-band feedback circuit is designed according to the multi-band feedback mechanism, to determine the difference in the responses, in the sensor circuit, of current signals in different frequency ranges from low frequency to high frequency; and multiple dynamic output feedback control circuits (each dynamic output feedback control circuit having a limited frequency band) are designed for different frequency domains for ensuring that the transmission characteristics of different frequencies are consistent.

The above embodiment adopts a multi-physical field interference suppression method, the zero drift is corrected by a detection circuit with a zero drift correction, the element performance error is corrected by the element error correction and compensation circuit module based on a signal injection method, and the possibly coupled electromagnetic field interference signals are filtered by an electromagnetic field interference filter. By adopting the multi-band feedback mechanism, the consistency of the transmission characteristics of different frequencies is ensured.

The feedback compensation unit 300 is configured to: adjust a feedback current based on the amplified voltage signal output by the signal processing unit 200 to enable the new magnetoresistance elements to operate at zero magnetic flux; measure a value of the feedback current; and obtain a value of the to-be-measured current based on the value of the feedback current, and output the value of the to-be-measured current.

Furthermore, the feedback compensation unit 300 includes: a feedback winding 301, a driving circuit 302 and an output circuit 303.

The feedback winding 301 is uniformly wound on the iron core, and configured to pass the feedback current.

The driving circuit 302 is configured to adjust the feedback current output to the feedback winding based on the amplified voltage signal output by the signal processing unit, to enable a compensation magnetic field equal in size and opposite in direction to a primary magnetic field.

The output circuit 303 is configured to: measure the value of the feedback current, obtain the value of the to-be-measured current based on the value of the feedback current, and output the value of the to-be-measured current.

Furthermore, the operation of obtaining the value of the to-be-measured current based on the value of the feedback current includes:

dividing the value of the feedback current by a ratio of coil turns to obtain the value of the to-be-measured current.

The amplified output voltage drives the push-pull transistor, to adjust the feedback current $I_c$ output to the compensation coil wound on the iron core, to enable the compensation magnetic field equal in size and opposite in direction to the primary magnetic field, allowing the TMR element to always operate near the zero magnetic flux; in this moment, the ratio of $I_c$ to the primary current $I_{in}$ is the ratio of coil turns. Then the voltage on the feedback current $I_c$ is measured by measuring the resistance, to obtain a result of measuring $I_{in}$. As a result, the actual magnetic field on the sensor is the difference between the external magnetic field and the feedback magnetic field, and the sensor actually operates within a very small magnetic field range.

Furthermore, the AC/DC multi-air-gap magnetoresistance current sensor further includes a ring housing for carrying the iron core wound with the feedback winding and the N new magnetoresistance elements connected in parallel. The ring housing is voltage insulated by using a special processed ring insulating layer.

Furthermore, the ring housing is voltage insulated by using an insulating layer.

FIG. 2 illustrates a schematic structural diagram of a housing of an AC/DC multi-air-gap magnetoresistance current sensor according to an embodiment of the disclosure. As illustrated in FIG. 2, the ring housing and the iron core wound with the feedback winding and the N new magnetoresistance elements connected in parallel carried inside the ring housing can form a sensing ring. The voltage insulated is realized by using a special processed ring insulation layer inside the sensing ring, and the power supply and the secondary circuit realize current sensing on the low-voltage side.

The ring housing is adopted to ensure the insulation performance of the sensor.

The above embodiment provides an AC/DC multi-air-gap magnetoresistance current sensor , which adopts a multi-air-gap multi-band closed-loop iron core type structure, thereby improving the measurement performance of the current sensor, solving the problem of high accuracy and wide frequency domain consideration of AC/DC current measurement , providing technical guidance for the development and application of high-voltage and high-current measurement equipment, and promoting the technology upgrade of high-voltage and high-current measurement equipment.

The embodiment of the disclosure also provides a method for measuring a current, including: using the AC/DC multi-air-gap magnetoresistance current sensor provided by the above embodiments to measure a to-be-measured current in a target current-carrying wire, to obtain a value of the to-be-measured current and output the value of the to-be-measured current. The target current-carrying wire is at a center of an iron core of the AC/DC multi-air-gap magnetoresistance current sensor .

The AC/DC multi-air-gap magnetoresistance current sensor and the method for measuring a current are designed in embodiments of the disclosure, the high interference sensitivity of the ring array current sensor is avoided, the error influence such as wire eccentricity and external interference are avoided and the hysteresis effect of the iron core is avoided, thereby solving the problem of high accuracy and wide frequency domain consideration in direct current measurement with high-voltage and high-current.

The AC/DC multi-air-gap magnetoresistance current sensor mainly includes: a magnetoelectric conversion section, a signal processing section and a feedback compensation section.

The magnetoelectric conversion section consists of an iron core, 4 TMR elements and a power supply circuit. Among them, the iron core is circular and the cross section is square, which is made of iron-based nanocrystalline alloy or permalloy material. The iron core is uniformly wound with a feedback winding, and 4 air-gap openings are symmetrically arranged on the iron core.

The 4 TMR elements of the magnetoelectric conversion section are respectively located at centers of the 4 air-gap openings of the iron core. The formula for calculating the input voltage of each TMR element refers to the aforementioned formula (1) when the iron core is placed around the current-carrying wire with the to-be-measured current I_in.

Because the current-carrying wire may not locate at the center of the iron core, the primary magnetic fields caused by the primary current at the air-gaps are different. The total magnetic field formed by the primary magnetic field and the feedback magnetic field in the air-gap at the $i$-th TMR element is represented as $B_i$. After connecting the circuits in parallel, synthesizing and obtaining the combined output voltages of the 4 TMR elements according to an equivalent circuit of parallel capacitors are as follows:

$$V_s = \sum_{i=1}^{4} K_i I_i B_i = \sum_{i=1}^{4} V_i$$

(2)

The combined output voltage of the TMR elements is input into the signal processing section.

In the power supply circuit of the magnetoelectric conversion section, a Low Dropout Regulator (LDO) chip is selected as the power supply of the TMR elements, using a 2.2 μF small ceramic output capacitor to maintain a stable of the fixed output voltage, which supplies power to four TMR elements. The temperature drift error correction and compensation circuit based on a thermistor is designed, and a same-phase proportional amplifier circuit is built through the thermistor with negative temperature coefficient, which adjusts the supply voltage of TMR sensing chip when the temperature changes.

The signal processing section consists of the detection circuit, the interference suppression circuit and the multi-band feedback circuit. The detection circuit is configured to amplify the weak output voltage with small amplitude of TMR element for operations and filtering. The detection circuit is mainly composed of an instrumentation amplifier with three operational amplifiers, and its REF pin is grounded to keep a very low source impedance. In the detection circuit, a zeroing circuit is designed, in which a precision adjustable resistor is connected in series between two equivalent resistors, and a precision operational amplifier is used as a voltage follower for buffering. The positive input terminal of the precision operational amplifier is connected to the middle pin of the precision adjustable resistor, and its output serves as an output of a zeroing voltage.

The interference suppression circuit of the signal processing section includes the element performance error correction circuit and the filtering circuit. The element performance error correction and compensation method based on a signal injection method is used through the decomposition unit according to the distinctive waveform characteristics, to identify the excitation signal from the current detected by TMR element, which is used to calculate the overall gain of the measuring loop of the magnetosensitive sensor, determine the change of the measurement characteristics of the magnetosensitive resistor chip, and generate a regulating current. The filter circuit is configured to filter the possibly coupled high-frequency magnetic field signal to ensure a low-pass characteristic. The filter circuit adopts a second-order Butterworth low-pass filter built based on a precision operational amplifier.

The multi-band feedback circuit of the signal processing section is designed according to the multi-band feedback mechanism. According to the difference in the responses, in the sensor circuit, of current signals at different frequencies, multiple dynamic output feedback control circuits (each dynamic output feedback control circuit having a limited frequency band) are designed, the optimization goal of which is to ensure that the transmission characteristics of different frequencies from low frequency to high frequency signals are consistent.

The feedback compensation section consists of the driving circuit, the feedback winding and the output circuit. The amplified output voltage drives the push-pull transistor, and the transistor outputs the feedback current $I_c$ to the compensation coil. During the period of not exceeding the measuring range, the magnetic field generated by the output current of the operational amplifier and transistor operating in the linear region is equal in size and opposite in direction to the measured magnetic field. The feedback winding receives the feedback current output by the transistor, the magnetic field may be generated by the feedback current, and represented as $B_c$:

$$B_c = \frac{\mu_0 N_2 I_c}{d} \tag{3}$$

where $I_c$ is the feedback current, $N_2$ is the number of turns of the compensation coil. When the compensation magnetic field cancels out the original magnetic field to reach the zero magnetic flux, that is:

$$\frac{\mu_0}{d}(N_2 I_c - I_{in}) = 0 \tag{4}$$

At this time, $N_2 I_c = I_{in}$ is obtained, that is to say, the ratio of $I_c$ to the primary current $I_{in}$ is the ratio of coil turns. Then the feedback current $I_c$ is measured according to Ohm's law, the result of measuring $I_{in}$ is obtained. As a result, the actual magnetic field on the sensor is the difference between the external magnetic field and the feedback magnetic field, and the sensor actually operates within a very small magnetic field range.

The design scheme of the external structure of the current sensor is as follows: according to the above high-voltage direct current quantum tunneling magnetoresistance current sensing method, the magnetoelectric conversion section is designed as a sensing ring. The voltage insulated is realized by using a special processed ring insulation layer inside the sensing ring, and the power supply and the secondary circuit realize current sensing on the low voltage side.

The AC/DC multi-air-gap magnetoresistance current sensor and the method for measuring a current are designed in the disclosure, including the following technical solutions:

(1) multi-air-gap multi-band closed-loop iron core type structure: the high interference sensitivity of the ring array current sensor is avoided through the magnetic gathering effect of the iron core, the wire eccentricity and non-uniform winding error of the single-air-gap iron core type structure are avoided through the multi-air-gap, and the hysteresis effect of the iron core is avoided through the zero magnetic flux closed-loop structure;

(2) multi-physical field interference suppression method: the temperature drift error is corrected by a power supply with the temperature drift error correction and compensation circuit, the zero drift is corrected by a detection circuit with a zero drift correction, the element performance error is corrected by the element error correction and compensation circuit module based on a signal injection method, and the possibly coupled electromagnetic field interference signals are filtered by an electromagnetic field interference filter;

(3) multi-band feedback mechanism: the consistency of the transmission characteristics of different frequencies is ensured;

(4) external structural design with ring insulation layer: the insulation performance of the sensor is ensured.

Through the above technical solutions, the measurement performance of quantum tunneling magnetoresistance current sensor is improved, the problem of high accuracy and wide frequency domain consideration of AC/DC current measurement is solved, the technical guidance is provided for the development and application of high-voltage and high-current measurement equipment, and the technology upgrade of high-voltage and high-current measurement equipment is promoted.

The disclosure provides an AC/DC multi-air-gap magnetoresistance current sensor , mainly including a magnetoelectric conversion section, a signal processing section and a feedback compensation section.

The magnetoelectric conversion section consists of an iron core, a power supply circuit and four TMR elements. Among them, the iron core is circular and the cross section is square, which is made of iron-based nanocrystalline alloy or permalloy material. The iron core is uniformly wound with a feedback winding, and four air-gap openings are symmetrically arranged on the iron core. The four TMR elements are respectively located at centers of the four air-gaps of the iron core. The combined output voltage of the TMR elements is input into the signal processing section.

In the power supply circuit of the magnetoelectric conversion section, an LDO chip is selected as the power supply of the TMR elements, using 2.2 $\mu$F small ceramic output capacitor to maintain a stable of the fixed output voltage, which supplies power to four TMR elements. The temperature drift error correction and compensation circuit based on a thermistor is designed, and a same-phase proportional amplifier circuit is built through the thermistor with negative temperature coefficient, which adjusts the supply voltage of TMR sensing chip when the temperature changes.

The signal processing section consists of the detection circuit, the interference suppression circuit and the multi-band feedback circuit. The detection circuit is configured to amplify the weak output voltage with small amplitude of TMR element for operations and filtering. The detection circuit is mainly composed of an instrumentation amplifier with three operational amplifiers, and its REF pin is grounded to keep a very low source impedance. In the detection circuit, a zeroing circuit is designed, in which a precision adjustable resistor is connected in series between two equivalent resistors, and a precision operational amplifier is used as a voltage follower for buffering. The positive input terminal of the precision operational amplifier is connected to the middle pin of the precision adjustable resistor, and its output serves as an output of a zeroing voltage.

The interference suppression circuit includes the element performance error correction circuit and the filtering circuit. The element performance error correction and compensation method based on a signal injection method is used through the decomposition unit according to the distinctive waveform characteristics, to identify the excitation signal from the current detected by TMR element, which is used to calculate the overall gain of the measuring loop of the magnetosensitive sensor, determine the change of the measurement characteristics of the magnetosensitive resistor chip, and generate a regulating current. The filter circuit is configured to filter the possibly coupled high-frequency magnetic field signal to ensure a low-pass characteristic. The filter circuit adopts a second-order Butterworth low-pass filter built based on a precision operational amplifier.

The multi-band feedback circuit is designed according to the multi-band feedback mechanism. According to the difference in the responses, in the sensor circuit, of current signals at different frequencies, multiple dynamic output feedback control circuits (each dynamic output feedback control circuit having a limited frequency band) are designed, the optimization goal of which is to ensure that the transmission characteristics of different frequencies from low frequency to high frequency signals are consistent.

The feedback compensation section consists of the driving circuit, the feedback winding and the output circuit. The amplified output voltage drives the push-pull transistor, and the transistor outputs the feedback current I_c to the compensation coil. At this time, the actual magnetic field on the sensor is the difference between the external magnetic field and the feedback magnetic field. Then, the feedback current is measured according to Ohm's law, the to-be-measured current is obtained through the ratio of the compensation coil turns.

The design scheme of the external structure of the current sensor is as follows: according to the above high-voltage direct current quantum tunneling magnetoresistance current sensing method, the magnetoelectric conversion section is designed as a sensing ring. The voltage insulated is realized by using a special processed ring insulation layer inside the sensing ring, and the power supply and the secondary circuit realize current sensing on the low voltage side.

The disclosure has been described with reference to some embodiments. However, known to those skilled in the art, as defined by the appended claims, other embodiments other than those disclosed above in the disclosure fall equivalently within the scope of the disclosure.

Generally, all terms used in the claims are construed according to their ordinary meanings in technical field, unless otherwise expressly defined therein. All references to "a/said/the [device, component, etc.]" are openly interpreted as at least one instance of the device, the component, etc., unless otherwise expressly stated. The operations of any of the methods disclosed herein need not be perform in the exact order disclosed, unless explicitly stated.

Those skilled in the art will appreciate that the embodiments of the disclosure are provided as a method, a system or a computer program product. Therefore, the disclosure may take the form of an entirely hardware embodiment, an entirely software embodiment, or an embodiment combining both software and hardware aspects. Furthermore, the disclosure may take the form of a computer program product implemented on one or more computer-readable storage medium (including, but not limited to, disk storage, CD-ROM, optical memory, etc.) containing computer-executable program codes.

The disclosure is described with reference to flowcharts and/or block diagrams of methods, apparatus (systems) and computer program products according to the embodiments of the disclosure. It should be understood that each flow in the flowchart and/or each block in the block diagram, as well as combinations of the flows in the flowchart and/or the blocks in the block diagram, may be implemented by computer program instructions. These computer program instructions may be provided to a processor of a general purpose computer, a special purpose computer, an embedded processor, or other programmable data processing device to generate a machine, such that instructions executed by the processor of the computer or other programmable data processing device generate a device for implementing the functions specified in one or more flows in the flowchart and/or one or more blocks in the block diagram.

These computer program instructions may also be stored in a computer-readable memory capable of directing a computer or other programmable data processing device to operate in a specific manner, such that the instructions stored in the computer-readable memory produce an article of manufacture containing an instruction device for implementing the functions specified in one or more flows in the flowchart and/or one or more blocks in the block diagram.

These computer program instructions may also be loaded onto a computer or other programmable data processing device, such that a series of operating operations is performed on the computer or other programmable device to generate computer-implemented processing, thereby the instructions executed on the computer or other programmable device provide operations for implementing the functions specified in one or more flows in the flowchart and/or one or more blocks in the block diagram.

The invention is defined by the appended claims.

Industrial Applicability

In the embodiment of the disclosure, the magnetoelectric conversion unit is configured to: obtain a magnetic field signal of a target current-carrying wire with a to-be-measured current; and convert the magnetic field signal into an electric signal and output the electric signal to the signal processing unit. The magnetoelectric conversion unit adopts a multi-air-gap multi-band closed-loop iron core type structure. The signal processing unit is configured to: amplify the electric signal, and output the amplified signal to the feedback compensation unit. The feedback compensation unit is configured to: adjust a feedback current based on the amplified voltage signal to enable the new magnetoresistance elements to operate at zero magnetic flux; measure a value of the feedback current; and obtain a value of the to-be-measured current based on the value of the feedback current, and output the value of the to-be-measured current. In this way, the AC/DC multi-air-gap magnetoresistance current sensor adopts a multi-air-gap multi-band closed-loop iron core type structure, thereby improving the measurement performance of the current sensor, solving the problem of high accuracy and wide frequency domain consideration of AC/DC current measurement , providing technical guidance for the development and application of high-voltage and high-current measurement equipment, and promoting the technology upgrade of high-voltage and high-current measurement equipment.

**Claims**

1.    An alternating current/direct current, AC/DC, multi-air-gap magnetoresistance current sensor, comprising:

a magnetoelectric conversion unit (100), configured to: obtain a magnetic field signal of a target current-carrying wire (400) with a to-be-measured current; and convert the magnetic field signal into a voltage signal and output the voltage signal to a signal processing unit (200), wherein the magnetoelectric conversion unit (100) comprises an iron core (101) and N new magnetoresistance elements (102) connected in parallel, N air-gap openings (104) are symmetrically arranged on the iron core (101), and the N new magnetoresistance elements (102) are respectively located at centers of the N air-gap openings (104), $N \geq 3$ and N is a positive integer;

the signal processing unit (200), configured to: amplify the voltage signal output by the magnetoelectric conversion unit (100), and output the amplified voltage signal to a feedback compensation unit (300); and

the feedback compensation unit (300), configured to: adjust a feedback current based on the amplified voltage signal output by the signal processing unit (200) to enable the N new magnetoresistance elements (102) to operate at zero magnetic flux; measure a value of the feedback current; and obtain a value of the to-be-measured current based on the value of the feedback current, and output the value of the to-be-measured current;

**characterized in that** the signal processing unit (200) comprises:

a detecting circuit (201), comprising an instrumentation amplifier with three operational amplifiers, wherein the detecting circuit (201) is configured to amplify the voltage signal output by the magnetoelectric conversion unit (100), and output the amplified voltage signal to the feedback compensation unit (300);

an interference suppression circuit (202), used for an element performance error correction circuit and a filtering circuit, wherein the element performance error correction circuit is configured to generate a regulating current based on the voltage signal output by the magnetoelectric conversion unit (100), and the filtering circuit is configured to filter high-frequency magnetic field signals coupled by the N new magnetoresistance elements (102) to ensure a low-pass characteristic; and

a multi-band feedback circuit (203), comprising a plurality of dynamic output feedback control circuits for ensuring that the transmission characteristics of different frequencies are consistent, each of the plurality of dynamic output feedback control circuits having a limited frequency band.

2. The AC/DC multi-air-gap magnetoresistance current sensor of claim 1, wherein

the iron core (101) is a circular magnetic gathering ring and is uniformly wound with a feedback winding (301), and the magnetoelectric conversion unit (100) further comprises a power supply circuit (103) which is respectively connected to the N new magnetoresistance elements (102) for power supply; and

when the target current-carrying wire (400) with the to-be-measured current is placed at a center of the iron core (101), the N new magnetoresistance elements (102) are used for obtaining the magnetic field signal of the target current-carrying wire (400) with the to-be-measured current, converting the magnetic field signal into the voltage signal, and outputting the voltage signal to the signal processing unit (200).

3. The AC/DC multi-air-gap magnetoresistance current sensor of claim 2, wherein the operation that the N new magnetoresistance elements (102) are used for obtaining the magnetic field signal of the target current-carrying wire (400) with the to-be-measured current, converting the magnetic field signal into the voltage signal and outputting the voltage signal to the signal processing unit (200), comprises:

obtaining an input voltage $V_i$ of each of the N new magnetoresistance elements (102) by the following formula:

$$V_i = K_i I_i (B_{in} - B_c)$$,

where $K_i$ is a sensitivity of $i$-th new magnetoresistance element, $I_i$ is a control current of the $i$-th new magnetoresistance element, $B_{in}$ is a primary original magnetic field, and $B_c$ is a compensation magnetic field generated by the feedback current; and

based on the input voltage of each of the N new magnetoresistance elements (102), synthesizing and obtaining a combined voltage of the N new magnetoresistance elements (102) according to an equivalent circuit of parallel capacitors, and outputting the combined voltages to the signal processing unit (200).

4. The AC/DC multi-air-gap magnetoresistance current sensor of claim 2, wherein the new magnetoresistance element is a tunneling magnetoresistance element.

5. The AC/DC multi-air-gap magnetoresistance current sensor of claim 2, wherein the feedback compensation unit (300) comprises:

the feedback winding (301), uniformly wound on the iron core (101), and configured to pass the feedback current; a driving circuit (302), configured to adjust the feedback current output to the feedback winding (301) based on the amplified voltage signal output by the signal processing unit (200), to enable a compensation magnetic field equal in size and opposite in direction to a primary magnetic field; and

an output circuit (303), configured to: measure the value of the feedback current, obtain the value of the to-be-measured current based on the value of the feedback current, and output the value of the to-be-measured current.

6. The AC/DC multi-air-gap magnetoresistance current sensor of claim 5, wherein the output circuit (303) is further configured to:

divide the value of the feedback current by a ratio of coil turns to obtain the value of the to-be-measured current.

7. The AC/DC multi-air-gap magnetoresistance current sensor of claim 5, wherein the AC/DC multi-air-gap magnetoresistance current sensor further comprises a ring housing for carrying the iron core (101) wound with the feedback winding (301) and the N new magnetoresistance elements (102) connected in parallel.

8. The AC/DC multi-air-gap magnetoresistance current sensor of claim 7, wherein the ring housing is voltage insulated by using an insulating layer.

9. A method for measuring a current, comprising: using the AC/DC multi-air-gap magnetoresistance current sensor of any one of claims 1 to 8 to measure a to-be-measured current in a target current-carrying wire, to obtain a value of the to-be-measured current and output the value of the to-be-measured current; wherein the target current-carrying wire is at a center of an iron core of the AC/DC multi-air-gap magnetoresistance current sensor.

**Patentansprüche**

1. Wechselstrom/Gleichstrom-Magnetowiderstandstromsensor mit Mehrluftspalten, AC/DC-Magnetowiderstand-Stromsensor mit Mehrluftspalten, umfassend:

eine magnetoelektrische Umwandlungseinheit (100), die konfiguriert ist zum: Erhalten eines Magnetfeldsignals eines Zielstromführungsdrahts (400) mit einem zu messenden Strom; und Umwandeln des Magnetfeldsignals in ein Spannungssignal und Ausgeben des Spannungssignals an eine Signalverarbeitungseinheit (200), wobei die magnetoelektrische Umwandlungseinheit (100) einen Eisenkern (101) und N neue Magnetowiderstandselemente (102), die parallel geschaltet sind, umfasst, N Luftspaltöffnungen (104) auf dem Eisenkern (101) symmetrisch angeordnet sind, und die N neuen Magnetowiderstandselemente (102) sich jeweils in Zentren der N Luftspaltöffnungen (104) befinden, N ≥ 3 und N eine positive ganze Zahl ist;
die Signalverarbeitungseinheit (200), die konfiguriert ist zum: Verstärken des Spannungssignals, das durch die magnetoelektrische Wandlereinheit (100) ausgegeben wird, und Ausgeben des verstärkten Spannungssignals an eine Rückkopplungskompensationseinheit (300); und
die Rückkopplungskompensationseinheit (300), die konfiguriert ist zum: Einstellen eines Rückkopplungsstroms basierend auf dem verstärkten Spannungssignal, das durch die Signalverarbeitungseinheit (200) ausgegeben wird, um es den N neuen Magnetowiderstandselementen (102) zu ermöglichen, bei null magnetischem Fluss betrieben zu werden; Messen eines Wert des Rückkopplungsstroms; und Erhalten eines Werts des zu messenden Stroms basierend auf dem Wert des Rückkopplungsstroms, und Ausgeben des Werts des zu messenden Stroms;
**dadurch gekennzeichnet, dass** die Signalverarbeitungseinheit (200) umfasst:

eine Detektionsschaltung (201), umfassend einen Instrumentenverstärker mit drei Operationsverstärkern, wobei die Detektionsschaltung (201) konfiguriert ist, um das Spannungssignal zu verstärken, das durch die magnetoelektrische Umwandlungseinheit (100) ausgegebenen wird, und das verstärkte Spannungssignal an die Rückkopplungskompensationseinheit (300) auszugeben;
eine Störungsunterdrückungsschaltung (202), die für eine Elementleistungsfehlerbehebungsschaltung und eine Filterschaltung verwendet wird, wobei die Elementleistungsfehlerbehebungsschaltung konfiguriert ist, um einen Regelstrom basierend auf dem Spannungssignal zu erzeugen, das durch die magnetoelektrische Wandlereinheit (100) ausgegeben wird, und die Filterschaltung konfiguriert ist, um hochfrequente Magnetfeldsignale zu filtern, die durch die N neuen Magnetowiderstandselemente (102) gekoppelt sind, um eine Tiefpasscharakteristik zu gewährleisten; und
eine Mehrbandrückkopplungsschaltung (203), umfassend eine Vielzahl von dynamischen Ausgangsrückkopplungssteuerschaltungen zum Gewährleisten, dass die Übertragungscharakteristiken unterschiedlicher Frequenzen konsistent sind, wobei jede der Vielzahl von dynamischen Ausgangsrückkopplungssteuerschaltungen ein begrenztes Frequenzband aufweist.

2. AC/DC-Magnetowiderstandstromsensor mit Mehrluftspalten nach Anspruch 1, wobei

der Eisenkern (101) ein kreisförmiger magnetischer Sammelring ist und gleichmäßig mit einer Rückkopplungswindung (301) gewunden ist, und die magnetoelektrische Wandlereinheit (100) ferner eine Leistungsversorgungsschaltung (103) umfasst, die jeweils mit den N neuen Magnetowiderstandselementen (102) für eine Leistungsversorgung verbunden ist; und
wenn der Zielstromführungsdraht (400) mit dem zu messenden Strom in einem Zentrum des Eisenkerns (101) platziert wird, die N neuen Magnetowiderstandselemente (102) zum Erhalten des Magnetfeldsignals des Zielstromführungsdrahts (400) mit dem zu messenden Strom, Umwandeln des Magnetfeldsignals in das Spannungssignal und Ausgeben des Spannungssignals an die Signalverarbeitungseinheit (200) verwendet werden.

3. AC/DC-Magnetowiderstandstromsensor mit Mehrluftspalten nach Anspruch 2, wobei die Operation, dass die N neuen Magnetowiderstandselemente (102) zum Erhalten des Magnetfeldsignals des Zielstromführungsdrahts (400) mit dem zu messenden Strom, Umwandeln des Magnetfeldsignals in das Spannungssignal und Ausgeben des Spannungssignals an die Signalverarbeitungseinheit (200) verwendet werden, umfasst:

Erhalten einer Eingangsspannung $V_i$ jedes der N neuen Magnetowiderstandselemente (102) durch die folgende Formel:

$$V_i = K_i I_i (B_{in} - B_c)$$

wobei $K_i$ eine Empfindlichkeit des $i$-ten neuen Magnetowiderstandselements ist, $I_i$ ein Steuerstrom des $i$-ten neuen Magnetowiderstandselements ist, $B_{in}$ ein primäres ursprüngliches Magnetfeld ist und $B_c$ ein Kompensationsmagnetfeld ist, das durch den Rückkopplungsstrom erzeugt wird; und
basierend auf der Eingangsspannung jedes der N neuen Magnetowiderstandselemente (102), Synthetisieren und Erhalten einer kombinierten Spannung der N neuen Magnetowiderstandselemente (102) gemäß einer äquivalenten Schaltung von parallelen Kondensatoren, und Ausgeben der kombinierten Spannungen an die Signalverarbeitungseinheit (200).

4. AC/DC-Magnetowiderstandstromsensor mit Mehrluftspalten nach Anspruch 2, wobei das neue Magnetowiderstandselement ein Tunnelmagnetowiderstandselement ist.

5. AC/DC-Magnetowiderstandstromsensor mit Mehrluftspalten nach Anspruch 2, wobei die Rückkopplungskompensationseinheit (300) umfasst:

die Rückkopplungswindung (301), die gleichmäßig auf den Eisenkern (101) gewickelt und konfiguriert ist, um den Rückkopplungsstrom zu leiten;
eine Ansteuerschaltung (302), die konfiguriert ist, um den Rückkopplungsstrom, der an die Rückkopplungswindung (301) ausgegeben wird, basierend auf dem verstärkten Spannungssignal, das durch die Signalverarbeitungseinheit (200) ausgegeben wird, einzustellen, um ein Kompensationsmagnetfeld, das gleich in der Größe und entgegengesetzt in einer Richtung zu einem primären Magnetfeld ist, zu ermöglichen; und
eine Ausgangsschaltung (303), die konfiguriert ist zum: Messen des Werts des Rückkopplungsstroms, Erhalten des Werts des zu messenden Stroms basierend auf dem Wert des Rückkopplungsstroms und Ausgeben des Werts des zu messenden Stroms.

6. AC/DC-Magnetowiderstandstromsensor mit Mehrluftspalten nach Anspruch 5, wobei die Ausgangsschaltung (303) ferner konfiguriert ist zum:
Dividieren des Werts des Rückkopplungsstroms durch ein Verhältnis von Spulenwindungen, um den Wert des zu messenden Stroms zu erhalten.

7. AC/DC-Magnetowiderstandstromsensor mit Mehrluftspalten nach Anspruch 5, wobei der AC/DC-Magnetowiderstandstromsensor mit Mehrluftspalten ferner ein Ringgehäuse zum Tragen des Eisenkerns (101) umfasst, der mit der Rückkopplungswindung (301) gewunden ist und der N parallel geschaltete neue Magnetowiderstandselemente (102) umfasst.

8. AC/DC-Magnetowiderstandstromsensor mit Mehrluftspalten nach Anspruch 7, wobei das Ringgehäuse durch Verwenden einer isolierenden Schicht spannungsisoliert ist.

9. Verfahren zum Messen eines Stroms, umfassend: Verwenden des AC/DC-Magnetowiderstandstromsensors mit Mehrluftspalten nach einem der Ansprüche 1 bis 8 zum Messen eines zu messenden Stroms in einem Zielstromführungsdraht, um einen Wert des zu messenden Stroms zu erhalten und den Wert des zu messenden Stroms auszugeben; wobei der Zielstromführungsdraht sich in einem Zentrum eines Eisenkerns des AC/DC-Magnetowiderstandstromsensors mit Mehrluftspalten befindet.

**Revendications**

1. Capteur de courant à magnétorésistance multi-entrefers à courant alternatif/courant continu, CA/CC, comprenant :

une unité de conversion magnétoélectrique (100), configurée pour : obtenir un signal de champ magnétique d'un fil conducteur cible (400) avec un courant à mesurer ; et convertir le signal de champ magnétique en un signal de tension et délivrer en sortie le signal de tension à une unité de traitement de signal (200), dans lequel l'unité de conversion magnétoélectrique (100) comprend un noyau de fer (101) et N nouveaux éléments de magnétorésistance (102) connectés en parallèle, N ouvertures d'entrefer (104) sont disposées symétriquement sur le noyau de fer (101), et les N nouveaux éléments de magnétorésistance (102) sont respectivement situés au niveau de centres des N ouvertures d'entrefer (104), N ≥ 3 et N est un nombre entier positif ;

l'unité de traitement de signal (200), configurée pour : amplifier le signal de tension délivré en sortie par l'unité de conversion magnétoélectrique (100), et délivrer en sortie le signal de tension amplifié à une unité de compensation de rétroaction (300) ; et

l'unité de compensation de rétroaction (300), configurée pour : ajuster un courant de rétroaction sur la base du signal de tension amplifié délivré en sortie par l'unité de traitement de signal (200) afin de permettre aux N nouveaux éléments de magnétorésistance (102) de fonctionner à un flux magnétique nul ; mesurer une valeur du courant de rétroaction ; et obtenir une valeur du courant à mesurer sur la base de la valeur du courant de rétroaction, et délivrer en sortie la valeur du courant à mesurer ;

**caractérisé en ce que** l'unité de traitement de signal (200) comprend :

un circuit de détection (201), comprenant un amplificateur de mesure avec trois amplificateurs opérationnels, dans lequel le circuit de détection (201) est configuré pour amplifier le signal de tension délivré en sortie par l'unité de conversion magnétoélectrique (100), et pour délivrer en sortie le signal de tension amplifié à l'unité de compensation de rétroaction (300) ;

un circuit antiparasite (202), utilisé pour un circuit de correction d'erreur de performance d'élément et un circuit de filtrage, dans lequel le circuit de correction d'erreur de performance d'élément est configuré pour générer un courant de régulation sur la base du signal de tension délivré en sortie par l'unité de conversion magnétoélectrique (100), et le circuit de filtrage est configuré pour filtrer des signaux de champ magnétique à haute fréquence couplés par les N nouveaux éléments de magnétorésistance (102) afin d'assurer une caractéristique passe-bas ; et

un circuit de rétroaction multibandes (203), comprenant une pluralité de circuits de commande de rétroaction de sortie dynamique destinés à garantir que les caractéristiques de transmission de différentes fréquences sont cohérentes, chacun de la pluralité de circuits de commande de rétroaction de sortie dynamique ayant une bande de fréquence limitée.

2. Capteur de courant à magnétorésistance multi-entrefers CA/CC selon la revendication 1, dans lequel

le noyau de fer (101) est un anneau de collecte magnétique circulaire et est enroulé uniformément avec un enroulement de rétroaction (301), et l'unité de conversion magnétoélectrique (100) comprend en outre un circuit d'alimentation électrique (103) qui est respectivement connecté aux N nouveaux éléments de magnétorésistance (102) pour l'alimentation électrique ; et

lorsque le fil conducteur cible (400) avec le courant à mesurer est placé au niveau d'un centre du noyau de fer (101), les N nouveaux éléments de magnétorésistance (102) sont utilisés pour obtenir le signal de champ magnétique du fil conducteur cible (400) avec le courant à mesurer, convertir le signal de champ magnétique en signal de tension, et délivrer en sortie le signal de tension à l'unité de traitement de signal (200).

3. Capteur de courant à magnétorésistance multi-entrefers CA/CC selon la revendication 2, dans lequel l'opération dans laquelle les N nouveaux éléments de magnétorésistance (102) sont utilisés pour obtenir le signal de champ magnétique du fil conducteur cible (400) avec le courant à mesurer, convertir le signal de champ magnétique en signal de tension et délivrer en sortie le signal de tension à l'unité de traitement de signal (200), comprend :

l'obtention d'une tension d'entrée $V_i$ de chacun des N nouveaux éléments de magnétorésistance (102) par la formule suivante :

$$V_i = K_i I_i (B_{in} - B_c),$$

où $K_i$ est une sensibilité du $i$-ième nouvel élément de magnétorésistance, $I_i$ est un courant de commande du $i$-ième nouvel élément de magnétorésistance, $B_{in}$ est un champ magnétique primaire initial, et $B_c$ est un champ magnétique de compensation généré par le courant de rétroaction ; et

sur la base de la tension d'entrée de chacun des N nouveaux éléments de magnétorésistance (102), la synthèse et l'obtention d'une tension combinée des N nouveaux éléments de magnétorésistance (102) selon un circuit équivalent de condensateurs parallèles, et la sortie des tensions combinées à l'unité de traitement de signal (200).

4. Capteur de courant à magnétorésistance multi-entrefers CA/CC selon la revendication 2, dans lequel le nouvel élément de magnétorésistance est un élément de magnétorésistance tunnel.

5. Capteur de courant à magnétorésistance multi-entrefers CA/CC selon la revendication 2, dans lequel l'unité de compensation de rétroaction (300) comprend :

l'enroulement de rétroaction (301), uniformément enroulé sur le noyau de fer (101), et configuré pour faire passer le courant de rétroaction ;
un circuit de pilotage (302), configuré pour ajuster le courant de rétroaction délivré en sortie à l'enroulement de rétroaction (301) sur la base du signal de tension amplifié délivré en sortie par l'unité de traitement de signal (200), afin de permettre un champ magnétique de compensation de taille égale et de direction opposée à un champ magnétique primaire ; et
un circuit de sortie (303), configuré pour : mesurer la valeur du courant de rétroaction, obtenir la valeur du courant à mesurer sur la base de la valeur du courant de rétroaction, et délivrer en sortie la valeur du courant à mesurer.

6. Capteur de courant à magnétorésistance multi-entrefers CA/CC selon la revendication 5, dans lequel le circuit de sortie (303) est en outre configuré pour :
diviser la valeur du courant de rétroaction par un rapport de spires de bobine afin d'obtenir la valeur du courant à mesurer.

7. Capteur de courant à magnétorésistance multi-entrefers CA/CC selon la revendication 5, dans lequel le capteur de courant à magnétorésistance multi-entrefers CA/CC comprend en outre un boîtier annulaire destiné à porter le noyau de fer (101) enroulé avec l'enroulement de rétroaction (301) et les N nouveaux éléments de magnétorésistance (102) connectés en parallèle.

8. Capteur de courant à magnétorésistance multi-entrefers CA/CC selon la revendication 7, dans lequel le boîtier annulaire est isolé en tension à l'aide d'une couche isolante.

9. Procédé destiné à mesurer un courant, comprenant : l'utilisation du capteur de courant à magnétorésistance multi-entrefers CA/CC selon l'une quelconque des revendications 1 à 8 pour mesurer un courant à mesurer dans un fil conducteur cible, afin d'obtenir une valeur du courant à mesurer et de délivrer en sortie la valeur du courant à mesurer ; dans lequel le fil conducteur cible est situé au niveau d'un centre d'un noyau de fer du capteur de courant à magnétorésistance multi-entrefers CA/CC.

**FIG. 1**

**FIG. 2**

**EP 4 521 123 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202310762174
- CN 2663991 Y
- CN 115420930 A
- CN 216847918 U